(19) **Europäisches Patentamt**

**European Patent Office**

**Office européen des brevets**

(11) **EP 0 589 954 B1**

(12) **EUROPEAN PATENT SPECIFICATION**

(45) Date of publication and mention
of the grant of the patent:
**25.11.1998 Bulletin 1998/48**

(21) Application number: **92911892.5**

(22) Date of filing: **17.06.1992**

(51) Int Cl.$^6$: **H03K 3/356**

(86) International application number:
**PCT/GB92/01084**

(87) International publication number:
**WO 92/22959 (23.12.1992 Gazette 1992/32)**

(54) **A VOLTAGE COMPARATOR**

SPANNUNGSVERGLEICHSCHALTUNG

COMPARATEUR DE TENSION ELECTRIQUE

(84) Designated Contracting States:
**DE FR GB IT NL**

(30) Priority: **17.06.1991 GB 91129981**

(43) Date of publication of application:
**06.04.1994 Bulletin 1994/14**

(73) Proprietor: **TEXAS INSTRUMENTS LIMITED
Bedford MK41 7PA (GB)**

(72) Inventor: **HALL, Andrew, Medlicott
The Hall Floor Flat
Cotham Bristol B56 6AP (GB)**

(74) Representative: **Abbott, David John et al
Abel & Imray
Northumberland House
303-306 High Holborn
London, WC1V 7LH (GB)**

(56) References cited:
**EP-A- 0 015 554          GB-A- 2 225 198
US-A- 4 814 642**

• **IEEE JOURNAL OF SOLID-STATE CIRCUITS.
vol. SC-21, no. 6, December 1986, NEW YORK US
pages 1088 - 1095; J. W. SCOTT: 'CMOS
Implementation of an Immediately Adaptive
Delta Modulator'**

## Description

The present invention relates to a voltage comparator.

The function of a voltage comparator is to provide an indication of which of two voltages applied to respective input ports of the voltage comparator is the larger.

A voltage comparator is disclosed in the IEEE Journal of Solid-State Circuits SC-21, No. 6, pages 1088 to 1095. The voltage comparator disclosed in the reference uses the storage effect of an insulated gate field effect transistor for offset voltage cancellation.

An object of the present invention is the provision of a voltage comparator which is especially suitable for fabrication as an integrated circuit.

According to the present invention, a method of operating a voltage comparator to provide an output signal indicating which of two voltages supplied to its input ports is the greater, includes the steps of:

generating, by means of voltage-to-current converters, respective first and second currents corresponding to the two applied voltages,

applying the first and second currents to respective active loads which are capable of being set to maintain operation at those currents,

setting the active loads to maintain operation at the first and second currents,

applying to the voltage-to-current converters, in place of the two applied voltages, a common input voltage that is the mean of the two applied voltages,

generating substantially equal currents corresponding to the common input voltage,

applying the substantially equal currents to the active loads in place of the first and second currents, the active loads being set to conduct the first and second currents, and

providing an output signal indicating the sense of any voltage change occurring at the active loads when the substantially equal currents are applied in place of the first and second currents.

The voltage comparator is capable of providing a substantial reduction in offset voltage compared with conventional voltage comparators without storing any offset voltage by means of a capacitor.

The invention provides a voltage comparator for comparing first and second input voltages, including:

a first voltage-to-current converter connected to apply a first current to a first active load,

first means for applying the first input voltage to the first voltage-to-current converter for causing the first voltage-to-current converter to apply the first current to the first active load while the first active load is in a first state, the first active load being a first voltage-controlled current sink operable in the first state to generate its own control voltage in order to conduct the first current,

a second voltage-to-current converter connected to apply a second current to a second active load,

second means for applying the second input voltage to the second voltage-to-current converter for causing the second voltage-to-current converter to apply the second current to the second active load while the second active load is in a first state, the second active load being a second voltage-controlled current sink operable in the first state to generate its own control voltage in order to conduct the second current,

means for applying, in place of the first and second input voltages, a common input voltage that is the mean of the first and second input voltages to cause the first and second voltage-to-current converters to apply corresponding substantially equal currents to the first and second active loads while the active loads are in respective second states, the active loads being operable in respective second states in which they store and respond only to the respective control voltages generated while conducting the respective first and second currents and

means for providing an output signal indicating the sense of any voltage change occurring at the active loads when the substantially equal currents are applied to the active loads while the active loads are in their respective second states.

Preferably, each active load includes an insulated gate field effect transistor (IGFET) which has its gate electrode connectable to its drain electrode by way of a switch means.

Preferably, a regenerative switching circuit is connected between the active loads for providing an output signal indicating the sense of any voltage change occurring at the active loads when the substantially equal currents are applied in place of the first and second currents.

Preferably, the regenerative switching circuit is a bistable latch circuit.

Preferably, the bistable latch circuit consists of a first and a second insulated gate field effect transistor (IGFET), the gate electrode of the first IGFET being connected to the drain electrode of the second IGFET and to one of the active loads, and the gate electrode of the second IGFET being connected to the drain electrode of the first IGFET and to the other active load.

One arrangement of the voltage comparator has a first input port connectible to a control port of the first voltage-to-current converter by way of first switch means, a second input port connectible to a control port of the second voltage-to-current converter by way of second switch means, the control ports of the voltage-to-currrent converters being capable of storing charge and being connectible together by third switch means, whereby, in operation, the first and second currents are generated with the third switch means non-conductive and the first and second switch means conductive and the substantially equal currents are generated with the third switch means conductive and the first and second switch means non-conductive.

Each active load utilised by the comparator is switchable between a first state in which it sinks a current supplied to it by adjusting its control voltage until its current is the same as the current supplied, and a second state in which the active load "remembers" the current supplied to it and maintains operation at that current by storing and responding only to the control voltage which it developed in the first state.

In operation, the switch means is conductive in order for the IGFET to generate its own control voltage and conduct the applied current, and the switch means is non-conductive in order for the IGFET to "remember" that current.

The voltage comparator disclosed above may be used in an analogue-to-digital converter.

A voltage comparator and a circuit arrangement forming a part of the voltage comparator, in accordance with the present invention, will now be described, by way of example only, with reference to the accompanying drawings in which:

Fig. 1 is a circuit diagram representing the voltage comparator, and
Fig. 2 is a circuit diagram representing the circuit arrangement.

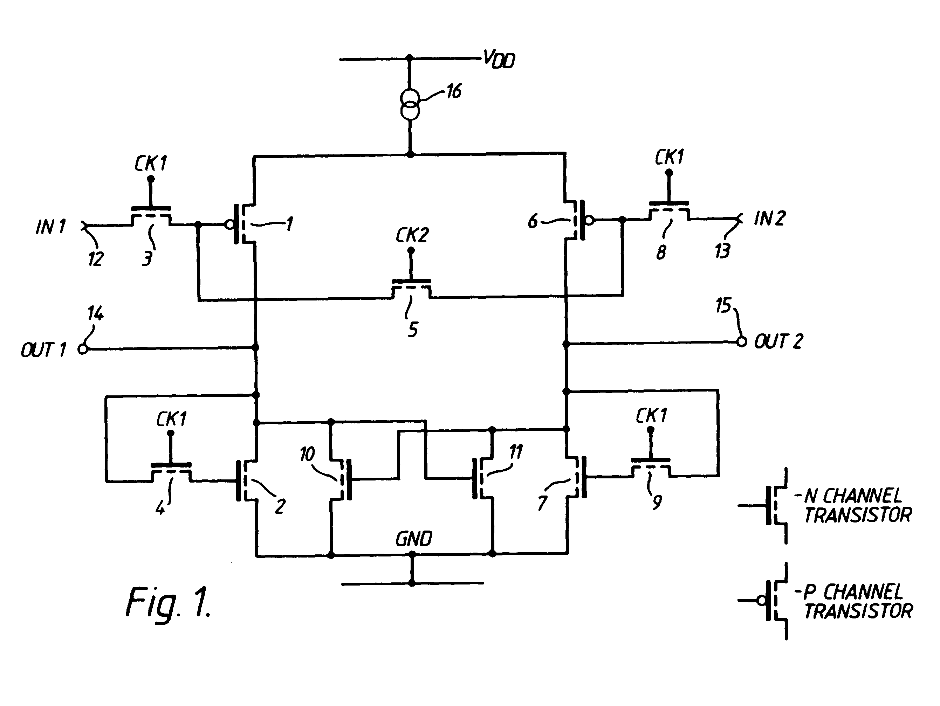

Referring to Fig. 1 of the accompanying drawings, the voltage comparator includes a first voltage-to-current converter consisting of a P-channel enhancement mode insulated gate field effect transistor (IGFET) 1, which is connected to an active load consisting of a first N-channel enhancement mode IGFET 2 connected drain electrode to drain electrode with the P-channel IGFET 1, and a second N-channel enhancement mode IGFET 4 the drain electrode of which is connected to the drain electrode of the first N-channel IGFET 2 and the source electrode of which is connected to the gate electrode of the first N-channel IGFET 2. A third IGFET 3 has its source electrode connected to the gate electrode of the IGFET 1.

Referring to Fig. 1, the voltage comparator includes a second voltage-to-current converter consisting of a second P-channel IGFET 6 which is connected drain electrode to drain electrode with a fourth N-channel IGFET 7, a fifth N-channel IGFET N-channel IGFET 9 the drain electrode of which is connected to the drain electrode of the N-channel IGFET 7 and the source electrode of which is connected to the gate electrode of the N-channel IGFET 7. A sixth IGFET 8 has its source electrode connected to the gate electrode of the IGFET 6. All of the IGFETS are enhancement mode devices.

Referring to Fig. 1, the voltage comparator includes a seventh N-channel IGFET 5 the drain electrode of which is connected to the gate electrode of the N-channel IGFET 6 and the source electrode of which is connected to the gate electrode of the N-channel IGFET 1. The connections of the N-channel IGFET 5 to the IGFETs 1 and 6 can be reversed.

Referring to Fig. 1, an eighth N-channel IGFET 10 is connected in parallel with the N-channel IGFET 2, drain electrode to drain electrode and source electrode to source electrode, and the gate electrode of the eighth N-channel IGFET 10 is connected to the drain electrode of the N-channel IGFET 7. A ninth N-channel IGFET 11 is connected in parallel with the N-channel IGFET 7, drain electrode to drain electrode and source electrode to source electrode, and the gate electrode of the transistor 11 is connected to the drain electrode of the N-channel IGFET 2. The source electrodes of the N-channel IGFETs 2, 7, 10 and 11 are connected together. The N-channel IGFETs 10 and 11 form a bistable latch connected between the drain electrodes of the N-channel IGFETs 2 and 7. The source electrodes of the N-channel IGFETs 1 and 6 are connected together. Current is supplied to the IGFETS 1 and 6 by way of a current source 16.

Referring to Fig. 1, the voltage comparator has a first input port 12 which is the drain electrode of the N-channel IGFET 3, a second input port 13 which is the drain electrode of the N-channel IGFET 8, a first output port 14 which is the common connection of the drain electrodes of the N-channel IGFETs 2, 4 and 10, and a second output port 15 which is the common connection of the drain electrodes of the N-channel IGFETs 7, 9 and 11. The voltage comparator has, also, a positive voltage supply port which is connected to the current source 16, and a negative voltage supply port which is the common connection of the source electrodes of the N-channel IGFETs 2, 7, 10 and 11.

The voltage comparator represented by Fig. 1 has two operating states.

When the voltage comparator of Fig. 1 is in the first operating state the N-channel IGFETs 3, 4, 8 and 9 are in their conductive state and the N-channel IGFET 5 is in its non-conductive state. Input voltages IN1 and IN2 applied to the input ports 12 and 13, respectively, are transmitted to the gate electrodes of the P-channel IGFETs 1 and 6, respectively, causing them to be conductive. In the case of the P-channel IGFET 1, current flows in its drain electrode, and the gate electrode of the N-channel IGFET 2 is charged by current reaching it by way of the N-channel IGFET 4. The charge established on the gate electrode of the N-channel IGFET 2 causes it to conduct and the IGFETs 1 and 2, together, establish a condition of dynamic equilibrium between their common drain currents and drain voltage, the gate voltage of the N-channel IGFET 2 being the same as its drain voltage by virtue of the connection of its drain electrode to its gate electrode by means of IGFET 4. The common drain current of the IGFETs 1 and 2 is dependent on the input voltage IN1. The IGFET 1 acts as a voltage to current converter. The IGFET 2, with the IGFET 4 conductive, acts as a current-to-voltage converter with its gate voltage such as to produce the required current. When the IGFET 4 is made non-conductive, the IGFET 2 continues to pass the current set up previously by virtue of the charge stored on its gate capacitance.

With the voltage comparator of Fig. 1 in the first operating state, the N-channel IGFETs 6 and 7 behave in a manner similar to the N-channel IGFETs 1 and 2, so the N-channel IGFETs 6 and 7, also, conduct a drain current dependent on the input voltage, which is IN2 in this case.

With the voltage comparator of Fig. 1 in the first operating state, if IN1 and IN2 are unequal, and say, IN1 is less than IN2, the drain voltage of the IGFETs 1 and 2 is higher than the drain voltage of the IGFETs 6 and 7. The difference between the two drain voltages is applied to the N-channel IGFETs 10 and 11 which become conductive but are unable to act as a bistable latch because the IGFETs 2 and 7 act as heavy loads which reduce the gain of the cross-connected IGFETs 10 and 11.

Referring to Fig. 1, with the voltage-to-current converter IGFETs 1 and 6 conducting currents dependent on the voltages IN1 and IN2, the N-channel IGFETs 3, 4, 8 and 9 are changed to their non-conductive state without affecting the currents flowing in the active loads 2 and 7, since the gate electrodes of the IGFETs 1, 2, 6 and 7 act as stores for the gate signals which give rise to the drain currents. That is, the IGFETs 1, 2, 6 and 7 are able to "remember" their respective conditions and to maintain their drain currents at the previous levels.

Referring to Fig. 1, the voltage at the output port 15 relative to that at the output port 14 indicates which of the input voltages IN1 and IN2 is the larger. However, the voltages present at the output ports 14 and 15 include an offset voltage caused by differences between the devices used in the voltage comparator, resulting in the two sides of the voltage comparator not being identical to each other and there being a small imbalance between the two sides of the circuit. More specifically, if the output voltages from the voltage comparator are OUT 1 and OUT 2, then;

OUT 1 - OUT 2 = -gain (IN1 - IN2 + OFFSET,) assuming that both voltage-to-current converters have substantially the same gain.

Referring to Fig. 1, an output signal with a substantially reduced offset voltage can be obtained by a change in the voltage comparator to its second operating state, which requires that the N-channel IGFET 5 be made conductive and the N-channel IGFETs 3, 4, 8 and 9 be made non-conductive. As has been explained above, the voltage-to-current converters and the active loads "remember" their currents after the N-channel IGFETs 3, 4, 8 and 9 are made non-conductive, so the conditions in the voltage comparator are substantially unaffected by the IGFETs 3, 4, 8 and 9 becoming non-conductive. The change in the condition of the N-channel IGFET 5 to its conductive state results in the equalisation of the charges stored by the gate electrodes of the IGFETs 1 and 6, a change in the drain currents of the IGFETs 1 and 6, and a change in the difference between the voltages present at the output ports 14 and 15. The voltage at one output port rises and the voltage at the other output port falls, the rise being equal in magnitude to the fall (because the average value of IN1 and IN2 will be $(\frac{IN1 + IN2}{2})$. The rise and fall of the voltages at the output ports 14 and 15 have the greatest effect on the IGFETs 10 and 11 since their gate electrodes are connected to those ports and the IGFETs 2 and 7 are now acting as high dynamic impedance "current memories". There is now enough gain to make the bistable latch consisting of the IGFETs 10 and 11 regenerative and to switch to a condition determined by the sense of the voltage change at the output ports 14 and 15, and that voltage change includes no offset voltage component.

Referring to Fig. 1, if the input voltages are INla and IN2a immediately before the equalisation of the charges at the gate electrodes of the IGFETs 1 and 6, and these input voltages are IN1b and IN2b immediately after that equalisation, where IN1b, in fact, is equal to IN2b, then the change in output voltage is:

[gain (IN1b - IN2b + offset)] - [gain x (IN1a - IN2a + offset)]

which is equal to gain x (IN1a - IN2a) since IN1b = IN2b. The expression gain x (IN1a - IN2a) is the change in the output voltage and includes no offset term.

In practice, the N-channel IGFETs 3, 4, 8 and 9 are operated by a first clock signal which switches them alternately on and off, and the N-channel IGFET 5 is operated by a second clock signal which switches it alternately on and off, the first and second clock signals being in anti-phase to each other.

The voltage comparator represented By Fig. 1 is especially suitable for use in flash analogue to digital converters using a digital CMOS fabrication process. This voltage comparator is capable of providing an output which is very little affected by offset voltage, because it is operable to provide offset voltage reduction, is fast in operation, because the latch which stores the result of the comparison is a positive feedback system with exponentially increasing gain, has good rejection of power supply noise, because the circuit symmetry ensures that differential voltages are not influenced by power supply noise, has very little charge injection at either input port, because there are open switches at the input ports when the result of the comparison is being determined, and is compact, because no capacitors are required to achieve offset reduction.

Referring to Fig. 1, the output rises exponentially with a time constant which can be expressed as:

$$t = \frac{K \times [\text{gate length}]^2}{\text{effective channel mobility} \times [v_{gs} - v_{th}]}$$

where the parameters are all for the latch IGFETs 10 and 11, $V_{gs}$ and $V_{th}$ being, respectively, the gate-source operating and threshold voltages for those IGFETs. Since the operating speed is dependent on the output time constant it is desirable to have short gate length IGFETs (of the order of 6 μm), large quiescent ($v_{gs} - V_{th}$), and high effective channel mobility. Very fast clock drivers are most effective for driving the comparator because there is some charge injection from the switches. The effect of the charge injection on circuit voltages has an exponential relationship to the clock rise and fall times and, also, to the clock skew, so these undesired effects can be reduced by increasing the clock edge speed.

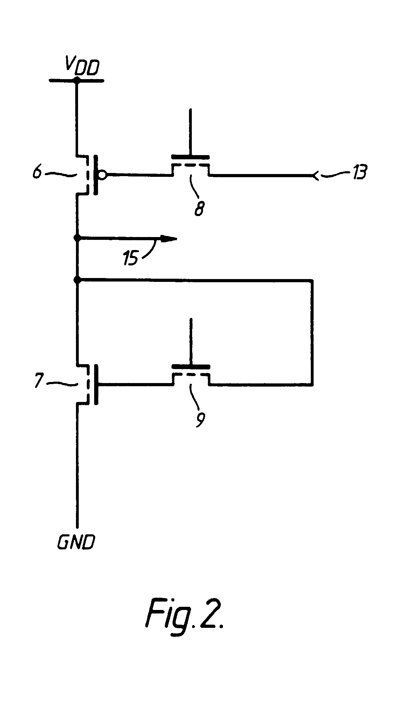

Fig. 2 shows the right hand (as viewed) voltage-to-current converter and active load of the voltage comparator of Fig. 1. As has been described above with reference to Fig. 1, with a voltage $V_{DD}$ applied directly to the source electrode of the IGFET 6, or applied through a current source, the source electrode of the IGFET 7 grounded, a signal voltage IN2 applied to the input port 13, and the IGFETs 8 and 9 switched on, that is, conductive, a current, substantially dependent on IN2 alone is established through the IGFETs 6 and 7. The IGFET 7 develops the correct gate voltage for it to pass the current supplied and the common drain voltage of the IGFETs 6 and 7 and the gate voltage of the IGFET 7 (which is the same as the common drain voltage of the IGFETs 6 and 7) is established by the devices. When the IGFETs 8 and 9 are switched off, that is, non-conductive, the signal voltage IN2 is stored on the gate electrode of the IGFET 6; also, the common drain voltage of the IGFETs 6 and 7 is stored on the gate electrode of the IGFET 7 as its gate voltage, with the result that the current flowing in the IGFETs 6 and 7 is maintained, or "remembered", after the removal of the signal IN2. If the charge stored on the gate electrode of the IGFET 6 is altered, that change is reflected as a change in the common drain voltage of the IGFETs 6 and 7, since the IGFET 7 will attempt to maintain its current at the original value. The IGFETs 7 and 9, therefore, form a current memory and is useful as a part of a voltage comparator, for example, as described above.

As will be evident from Fig. 1 and 2, the voltage comparator described above avoids the need for a capacitor dedicated to storing an offset signal, so any additional processing steps for providing such a capacitor are avoided. This comparator fabricated as an integrated circuit could be smaller than a conventional comparator by an amount equal to the relatively large areas that a dedicated capacitor requires.

Also, in comparison with the voltage comparator represented by Fig. 1, known comparators have poor rejection of power supply noise, low input impedance at one of the input ports during the comparison phase, and require many stages to achieve the high gains needed for high-speed operation (they lack the regeneration of the latch stage used in this comparator). This voltage comparator does not require a separate step for offset storage as the offset is dealt with in the same step as that in which an output signal is provided.

## Claims

1. A method of operating a voltage comparator to provide an output signal (OUT1, OUT2) indicating which of two voltages supplied to its input ports (12, 13) is the greater, including the steps of:

   generating, by means of voltage-to-current converters (1, 6), respective first and second currents corresponding to the two applied voltages,
   applying the first and second currents to respective active loads (2, 7) which are capable of being set to maintain operation at those currents,
   setting the active loads to maintain operation at the first and second currents,
   applying to the voltage-to-current converters, in place of the two applied voltages, a common input voltage that is the mean of the two applied voltages,
   generating substantially equal currents corresponding to the common input voltage,
   applying the substantially equal currents to the active loads in place of the first and second currents, the active loads being set to conduct the first and second currents, and
   providing an output signal indicating the sense of any voltage change occurring at the active loads when the substantially equal currents are applied in place of the first and second currents.

2. A voltage comparator for comparing first and second input voltages, including:

a first voltage-to-current converter (1) connected to apply a first current to a first active load (2,4),
first means (12,3) for applying the first input voltage to the first voltage-to-current converter (1) for causing the first voltage-to-current converter (1) to apply the first current to the first active load (2,4) while the first active load (2,4) is in a first state, the first active load (2,4) being a first voltage-controlled current sink operable in the first state to generate its own control voltage in order to conduct the first current,
a second voltage-to-current converter (6) connected to apply a second current to a second active load (7,9),
second means (13,8) for applying the second input voltage to the second voltage-to-current converter (6) for causing the second voltage-to-current converter (6) to apply the second current to the second active load (7,9) while the second active load (7,9) is in a first state, the second active load (7,9) being a second voltage-controlled current sink operable in the first state to generate its own control voltage in order to conduct the second current,
means (5) for applying, in place of the first and second input voltages, a common input voltage that is the mean of the first and second input voltages to cause the first and second voltage-to-current converters (1,6) to apply corresponding substantially equal currents to the first and second active loads (2,4,7,9) while the active loads (2,4,7,9) are in respective second states, the active loads (2,4,7,9) being operable in respective second states in which they store and respond only to the respective control voltages generated while conducting the respective first and second currents and
means (14,15) for providing an output signal (OUT 1,OUT 2) indicating the sense of any voltage change occurring at the active loads (2,4,7,9) when the substantially equal currents are applied to the active loads (2,4,7,9) while the active loads (2,4,7,9) are in their respective second states.

3. A voltage comparator as claimed in claim 2, wherein each active load (2,4;7,9) includes an IGFET which has its gate electrode connectable to its drain electrode by way of a switch means.

4. A voltage comparator as claimed in claim 2 or claim 3, wherein a regenerative switching circuit (10,11) is connected between the active loads for providing an output signal indicating the sense of any voltage change occurring at the active loads when the substantially equal currents are applied in place of the first and second currents.

5. A voltage comparator as claimed in claim 4, wherein the regenerative switching circuit is a bistable latch circuit.

6. A voltage comparator as claimed in claim 5, wherein the bistable latch circuit consists of a first and second insulated gate field effect transistors (IGFETs), the gate electrode of the first IGFET being connected to the drain electrode of the second IGFET and to one of the active loads, and the gate electrode of the second IGFET being connected to the drain electrode of the first IGFET and to the other active load.

7. A voltage comparator as claimed in any one of claims 2 to 6, which has a first input port (12) connectable to a control port of said first voltage-to-current converter by way of first switch means (3), a second input port (13) connectable to a control port of said second voltage-to-current converter by way of second switch means (8), the control ports of the voltage-to-current converters being capable of storing charge and being connectable together by third switch means, whereby in operation, the first and second currents are generated with the third switch means non-conductive and the first and second switch means conductive and the substantially equal currents are generated with the third switch means conductive and the first and second switch means non-conductive.

8. An analogue-to-digital converter including a voltage comparator as claimed in any of claims 2 to 7.

**Patentansprüche**

1. Verfahren zum Betreiben eines Spannungskomparators, um ein Ausgangssignal (OUT1, OUT2) zu erzeugen, das anzeigt, welche der beiden an seine Eingangsanschlüsse (12, 13) angelegten Spannungen die größere ist, bei dem

durch Spannung-Strom-Wandler (1, 6) ein erster Strom und ein zweiter Strom erzeugt werden, die jeweils einer der beiden angelegten Spannungen entsprechen,
der erste Strom und der zweite Strom jeweils an eine aktive Last (2, 7) angelegt werden, die so eingestellt werden kann, daß der Betrieb bei diesem Strom aufrecht erhalten werden kann,
die aktiven Lasten eingestellt werden, um den Betrieb bei dem ersten Strom und dem zweiten Strom aufrechtzuerhalten,
an die Spannung-Strom-Wandler an Stelle der beiden angelegten Spannungen eine gemeinsame Eingangsspannung angelegt wird, die dem Mittelwert der beiden angelegten Spannungen entspricht,
im wesentlichen gleiche Ströme erzeugt werden, die der gemeinsamen Eingangsspannung entsprechen,
die im wesentlichen gleichen Ströme an Stelle des ersten Stroms und des zweiten Stroms an die aktiven Lasten angelegt werden, die so eingestellt werden, daß sie den ersten Strom und den zweiten Strom leiten, und
ein Ausgangssignal erzeugt wird, das die Richtung einer Spannungsänderung anzeigt, die an den aktiven Lasten auftritt, wenn die im wesentlichen gleichen Ströme an Stelle des ersten Stroms und des zweiten Stroms angelegt werden.

2. Spannungskomparator zum Vergleichen einer ersten Eingangsspannung mit einer zweiten Eingangsspannung mit

einem ersten Spannung-Strom-Wandler (1), der so geschaltet ist, daß ein erster Strom einer ersten aktiven Last (2, 4) zugeführt wird,
ersten Mitteln (12, 3), die dazu dienen, die erste Eingangsspannung an den ersten Spannung-Strom-Wandler (1) anzulegen, um den ersten Spannung-Strom-Wandler (1) dazu zu bringen, den ersten Strom an die erste aktive Last (2, 4) anzulegen, während sich die erste aktive Last (2, 4) in einem ersten Zustand befindet, wobei die erste aktive Last (2, 4) eine erste spannungsgesteuerte Stromsenke ist, die in dem ersten Zustand betrieben werden kann, um ihre eigene Steuerspannung zur Führung des ersten Stroms zu erzeugen,
einem zweiten Spannung-Strom-Wandler (6), der so geschaltet ist, daß ein zweiter Strom einer zweiten aktiven Last (7, 9) zugeführt wird,
zweiten Mitteln (13, 8), die dazu dienen, die zweite Eingangsspannung an den zweiten Spannung-Strom-Wandler (6) anzulegen, um den zweiten Spannung-Strom-Wandler (6) dazu zu bringen, den zweiten Strom an die zweite aktive Last (7, 9) anzulegen, während sich die zweite aktive Last (7, 9) in einem ersten Zustand befindet, wobei die zweite aktive Last (7, 9) eine zweite spannungsgesteuerte Stromsenke ist, die in dem ersten Zustand betrieben werden kann, um ihre eigene Steuerspannung zur Führung des zweiten Stroms zu erzeugen,
Mitteln (5), um an Stelle der ersten Eingangsspannung und der zweiten Eingangsspannung eine gemeinsame Eingangsspannung, die dem Mittelwert aus der ersten Eingangsspannung und der zweiten Eingangsspannung entspricht, anzulegen, um den ersten Spannung-Strom-Wandler (1) und den zweiten Spannung-Strom-Wandler (6) dazu zu bringen, entsprechende im wesentlichen gleiche Ströme an die erste aktive Last (2, 4) und die zweite aktive Last (7, 9) anzulegen, während die aktiven Lasten (2, 4; 7, 9) sich in jeweiligen zweiten Zuständen befinden, wobei die aktiven Lasten (2, 4; 7, 9) in jeweiligen zweiten Zuständen betrieben werden können, in denen sie die jeweiligen Steuerspannungen speichern und nur auf diese reagieren, die während des Leitens des ersten Stroms bzw. des zweiten Stroms erzeugt wurden, und
Mitteln (14, 15) zum Erzeugen eines Ausgangssignals (OUT1, OUT2), das die Richtung einer Spannungsänderung anzeigt, die an den aktiven Lasten (2, 4; 7, 9) auftritt, wenn die im wesentlichen gleichen Ströme an die aktiven Lasten (2, 4; 7, 9) angelegt werden, während sich die aktiven Lasten (2, 4; 7, 9) in ihren jeweiligen zweiten Zuständen befinden.

3. Spannungskomparator nach Anspruch 2, bei dem jede aktive Last (2, 4; 7, 9) einen IGFET umfaßt, dessen Gateelektrode mittels eines Schaltermittels mit seiner Drainelektrode verbindbar ist.

4. Spannungskomparator nach Anspruch 2 oder Anspruch 3, bei dem eine regenerative Schaltschaltung (10, 11) zwischen die aktiven Lasten geschaltet ist, um ein Ausgangssignal zu erzeugen, das die Richtung einer Spannungsänderung anzeigt, die an den aktiven Lasten auftritt, wenn die im wesentlichen gleichen Ströme an Stelle des ersten Stroms und des zweiten Stroms angelegt werden.

5. Spannungskomparator nach Anspruch 4, bei dem die regenerative Schaltschaltung aus einer bistabilen Kippschaltung besteht.

6. Spannungskomparator nach Anspruch 5, bei dem die bistabile Kippschaltung aus einem ersten Feldeffekttransistor mit isolierter Gateelektrode (IGFET) und einem zweiten Feldeffekttransistor mit isolierter Gateelektrode (IGFET) besteht, wobei die Gateelektrode des ersten IGFETs mit der Drainelektrode des zweiten IGFETs und einer der aktiven Lasten verbunden ist und die Gateelektrode des zweiten IGFETs mit der Drainelektrode des ersten IGFETs und der anderen aktiven Last verbunden ist.

7. Spannungskomparator nach einem der Ansprüche 2 bis 6, bei dem ein erster Eingangsanschluß (12) mittels ersten Schaltermitteln (3) mit einem Steueranschluß des ersten Spannung-Strom-Wandlers und ein zweiter Eingangsanschluß (13) mittels zweiten Schaltermitteln (8) mit einem zweiten Spannung-Strom-Wandler verbindbar ist, wobei die Steueranschlüsse der Spannung-Strom-Wandler Ladung speichern und durch dritte Schaltermittel miteinander verbunden werden können, wodurch im Betrieb der erste Strom und der zweite Strom erzeugt werden, wenn die dritten Schaltermittel nichtleitend und die ersten Schaltermittel und die zweiten Schaltermittel leitend sind, und die im wesentlichen gleichen Ströme erzeugt werden, wenn die dritten Schaltermittel leitend und die ersten Schaltermittel und die zweiten Schaltermittel nichtleitend sind.

8. Analog-Digital-Wandler mit einem Spannungskomparator nach einem der Ansprüche 2 bis 7.

**Revendications**

1. Procédé permettant de faire fonctionner un comparateur de tension pour obtenir un signal de sortie (OUT1, OUT2) indiquant celle de deux tensions délivrées à ses ports d'entrée (12, 13) qui est la plus grande, ledit procédé comprenant les étapes consistant :

à générer, au moyen de convertisseurs tension-courant (1, 6), un premier et un second courant respectifs correspondant aux deux tensions appliquées,
à appliquer le premier et le second courant à des charges actives respectives (2, 7) qui peuvent être réglées pour maintenir un fonctionnement à ces niveaux de courant,
à régler les charges actives pour maintenir un fonctionnement aux niveaux du premier et du second courants,
à appliquer aux convertisseurs tension-courant, au lieu des deux tensions appliquées, une tension d'entrée commune qui est la moyenne des deux tensions appliquées,
à générer des courants sensiblement égaux correspondant à la tension d'entrée commune,
à appliquer les courants sensiblement égaux aux charges actives au lieu du premier et du second courant, les charges actives étant réglées pour acheminer le premier et le second courant, et
à fournir un signal de sortie indiquant le sens d'une variation de tension quelconque se produisant dans les charges actives lorsque les courants sensiblement égaux sont appliqués en lieu et place du premier et du second courant.

2. Comparateur de tension pour comparer une première et une seconde tension d'entrée, comprenant :

un premier convertisseur tension-courant (1) connecté pour appliquer un premier courant à une première charge active (2, 4),
un premier moyen (12, 3) pour appliquer la première tension d'entrée au premier convertisseur tension-courant (1) pour amener le premier convertisseur tension-courant (1) à appliquer le premier courant à la première charge active (2, 4), tandis que la première charge active (2, 4) est dans un premier état, la première charge active (2, 4) étant un premier puits de courant commandé en tension qui peut fonctionner dans le premier état pour générer sa propre tension de commande afin d'acheminer le premier courant,
un second convertisseur tension-courant (6) connecté pour appliquer un second courant à une seconde charge active (7, 9),
un second moyen (13, 8) pour appliquer la seconde tension d'entrée au second convertisseur tension-courant (6) pour amener le second convertisseur tension-courant (6) à appliquer le second courant à la seconde charge active (7, 9), tandis que la seconde charge active (7, 9) est dans un premier état, la seconde charge active (7, 9) étant un second puits de courant commandé en tension qui peut fonctionner dans le premier état pour générer sa propre tension de commande afin d'acheminer le second courant,
un moyen (5) pour appliquer, en lieu et place de la première et de la seconde tension d'entrée, une tension d'entrée commune qui est la moyenne de la première et de la seconde tension d'entrée pour amener le premier et le second convertisseurs tension-courant (1, 6) à appliquer des courants sensiblement égaux correspondants à la première et à la seconde charge active (2, 4, 7, 9), tandis que les charges actives (2, 4, 7, 9) sont dans des seconds états respectifs, les charges actives (2, 4, 7, 9) étant à même de fonctionner dans des seconds états respectifs dans lesquels elles stockent et ne répondent qu'aux tensions de commande respectives générées tout en acheminant le premier et le second courant respectif, et
un moyen (14, 15) pour fournir un signal de sortie (OUT1, OUT2) indiquant le sens d'une variation de tension quelconque se produisant sur les charges actives (2, 4, 7, 9) lorsque les courants sensiblement égaux sont appliqués aux charges actives (2, 4, 7, 9) tandis que les charges actives (2, 4, 7, 9) se trouvent dans leurs seconds états respectifs.

3. Comparateur de tension selon la revendication 2, dans lequel chaque charge active (2, 4, 7, 9) comprend un transistor à effet de champ à grille isolée (IGFET) qui a son électrode de grille qui peut être connectée à son électrode de drain par un moyen de commutation.

4. Comparateur de tension selon la revendication 2 ou 3, dans lequel un circuit de commutation régénérateur (10, 11) est connecté entre les charges actives pour fournir un signal de sortie indiquant le sens d'une variation de tension quelconque se produisant sur les charges actives lorsque les courants sensiblement égaux sont appliqués en lieu et place du premier et du second courant.

5. Comparateur de tension selon la revendication 4, dans lequel le circuit de commutation régénérateur est un circuit à bascule bistable.

6. Comparateur de tension selon la revendication 5, dans lequel le circuit à bascule bistable est constitué d'un premier et d'un second transistor à effet de champ à grille isolée (IGFET), l'électrode de grille du premier IGFET étant connectée à l'électrode de drain du second IGFET et à l'une des charges actives, et l'électrode de grille du second IGFET étant connectée à l'électrode de drain du premier IGFET et à l'autre charge active.

7. Comparateur de tension selon l'une quelconque des revendications 2 à 6, qui présente un premier port d'entrée (12) qui peut être connecté à un port de commande dudit premier convertisseur tension-courant par un premier moyen de commutation (3), un second port d'entrée (13) qui peut être connecté à un port de commande dudit second convertisseur tension-courant par un deuxième moyen de commutation (8), les ports de commande des convertisseurs tension-courant étant à même de stocker une charge et d'être connectés ensemble par un troisième moyen de commutation, de telle sorte qu'en fonctionnement, le premier et le second courant soient générés alors que le troisième moyen de commutation n'est pas conducteur et que le premier et le deuxième moyen de commutation sont conducteurs et que les courants sensiblement égaux soient générés lorsque le troisième moyen de commutation est conducteur et que le premier et le deuxième moyen de commutation ne sont pas conducteurs.

8. Convertisseur analogique-numérique comprenant un comparateur de tension selon l'une quelconque des revendications 2 à 7.

Fig. 1.

Fig.2.